# FASCICULE DE BREVET EUROPEEN

(11) **EP 1 975 856 B1**
(45) Date de publication et mention de la délivrance du brevet: **11.08.2010**
(21) Numéro de dépôt: 08102850.8
(22) Date de dépôt: 21.03.2008
(51) Int. Cl.: G06K 19/077, H01L 23/14, H01L 23/498

(54) **Module électronique mince pour carte à microcircuit**
Dünnes elektronisches Modul für Mikrochip-Karte
Thin electronic module for a microcircuit card

(30) Priorité: 30.03.2007 FR 0702352
(43) Date de publication de la demande: 01.10.2008
(73) Titulaire: OBERTHUR TECHNOLOGIES, 75017 Paris (FR)
(72) Inventeur: Enouf, Guy, 14190 Saint Sylvain (FR)
(74) Mandataire: Esselin, Sophie

(56) Documents cités:
- DE-A1- 10 101 280
- FR-A- 2 797 075
- FR-A- 2 826 154
- FR-A- 2 861 201
- US-A1- 2005 136 634

## Description

La présente invention concerne les modules électroniques destinés à être montés dans des cartes à microcircuit de faible épaisseur, par exemple d'épaisseur inférieure au millimètre, comme celles répondant à la norme ISO 7816 qui définit une épaisseur égale environ à 0,8mm.

Ces modules électroniques comportent un ou plusieurs micro-composants électroniques, dont un ou plusieurs circuits intégrés, montés sur un support à circuit imprimé appelé "vignette"pouvant comporter au dos des contacts électriques affleurants destinés à être raccordés à ceux d'un lecteur de carte. Ils s'intègrent dans une cavité creusée dans l'épaisseur d'une carte à microcircuit et sont fixés par collage soit au fond soit sur les bords en gradins de la cavité qui peut être débouchante ou non selon que la vignette présente ou non au dos, des contacts électriques affleurants.

La vignette d'un module est un support flexible car elle doit résister aux flexions que la carte à microcircuit est amenée à subir au cours de sa vie. Elle est généralement constituée d'un circuit imprimé flexible en epoxy ou polyimide, revêtu de motifs conducteurs de dimensions supérieures à 25µm tandis que le ou les micro-composants électroniques qui y sont montés, comportent généralement un ou plusieurs circuits intégrés à substrat en silicium présentant des plots de connexion plus ou moins proches et nombreux.

L'épaisseur d'un module ne peut dépasser typiquement, 450µm. En effet, la profondeur de la cavité prévue pour son logement dans une carte de 0,8mm d'épaisseur n'excède pas 600µm (typiquement, moins de 500 µm) car il faut laisser au fond de la cavité une épaisseur de plastique suffisante pour qu'il reste opaque et conserve une certaine résistance mécanique. De plus, un espace de 100 à 150µm doit être ménagé entre le module, le fond ou certains bords de sa cavité pour réduire les contraintes de rupture imposées au module par les efforts de cisaillement induits par des flexions de la carte. Cet espace est rempli d'une lame d'air ou d'une colle.

La réalisation des connexions électriques entre le circuit imprimé flexible de la vignette d'un module, et les circuits intégrés qui y sont montés, se fait habituellement selon les techniques classiques de la puce retournée ("Flip Chip" en anglo-saxon) ou du câblage par fils ("Wire Bonding" en anglo-saxon). Notamment, la demande de brevet français FR 2.797.075 décrit une carte à puce comportant : un support souple supportant une première puce de circuit intégré sur laquelle est montée une deuxième puce de circuit intégré et éventuellement une troisième. Les puces sont interconnectées entre elles et à une grille de contact disposée sur la face externe du support souple, à travers des puits de connexion. Les interconnexions sont réalisées par câblage filaire, celles entre les puces pouvant se faire également par jet de matières conductrices. Ces techniques de connexion posent des problèmes de rendement dès que le nombre de connexions à réaliser avec un même composant dépasse la dizaine, comme par exemple lorsqu'il faut interconnecter un composant mémoire à un microcontrôleur au moyen du circuit imprimé flexible d'une vignette de module électronique prévu pour une carte à microcircuit conforme à la norme internationale ISO 7816. En effet, la technique de la puce retournée devient inutilisable à cause des déformations subies par la vignette lors du report de la puce (c'est à dire lors du montage du microcircuit) et du grand nombre de plots de connexion tandis que la technique du câblage par fils ne peut être employée qu'avec des fils particulièrement fins étant donnée la petitesse et la proximité des plots de connexion, par exemple distants de 100µm, imposée par le nombre élevé de connexion et la miniaturisation des composants pour module.

Par ailleurs, on connaît de la demande de brevet US 2005/0136634 l'utilisation d'une plaquette intercalaire en silicium pourvue de plusieurs plans de réseau de câblage d'interconnexion pour réduire la longueur des connexions entre des puces de circuit intégré.

La présente invention a pour but de faciliter le montage des modules électroniques destinés à des cartes à microcircuit de faible épaisseur. Plus généralement, elle a pour but d'améliorer le rendement des opérations d'interconnexion électriques entre des composants électroniques à nombreux plots de contacts, montés sur un support souple tout en facilitant l'obtention d'assemblages de faible épaisseur résistant aux flexions.

Elle a pour objet un module électronique pour carte à microcircuit, comportant au moins un composant électronique à plusieurs plots de raccordement électrique et un support souple avec une face dite interne tournée vers le ou lesdits composants, et une face externe à plots de contacts électriques affleurants permettant la communication par contact à un équipement de lecture, remarquable en ce qu'il comporte en outre une plaquette intercalaire rigide d'interconnexion fixée à la face interne du support souple par une première face et supportant, sur sa deuxième face, un ou des composants électroniques et en ce que ladite plaquette comporte un réseau de câblage d'interconnexion pour les plots de contacts électriques du support souple et le ou les composants électroniques, au moyen d'un câblage par fils selon la technique dite "wire bonding" raccordant des plots de contact électrique au dit réseau d'interconnexion et d'un montage des composants électroniques sur ladite plaquette selon la technique de la puce retournée dite "flip chip".

Avantageusement, la plaquette intercalaire rigide d'interconnexion comporte un substrat de silicium supportant au moins un niveau de métallisation dans lequel est gravé un ensemble de pistes conductrices formant un réseau de câblage d'interconnexion pour les composants électroniques du module.

Avantageusement, la plaquette intercalaire rigide d'interconnexion comporte un substrat de silicium supportant deux niveaux de métallisation séparés par un niveau de passivation, reliés entre eux par des trous conducteurs ou "vias", et comportant un ensemble de pistes conductrices obtenues par photolithographie et formant un réseau de câblage d'interconnexion pour les composants électroniques du module.

Avantageusement, le support souple supporte des spires d'antenne raccordées aux composants électroniques par l'intermédiaire du réseau de câblage d'interconnexion de la plaquette intercalaire rigide d'interconnexion.

Avantageusement, la plaquette intercalaire rigide d'interconnexion a une surface égale à environ la moitié de celle du support souple.

Avantageusement, la plaquette intercalaire rigide d'interconnexion présente une épaisseur de l'ordre de 150 à 250µm.

Avantageusement, la plaquette intercalaire rigide d'interconnexion est un circuit imprimé en verre époxy.

Avantageusement, le support souple a une épaisseur de l'ordre de 50µm.

Avantageusement, le support souple est en polyimide.

Avantageusement, le support souple est en époxy flexible.

Avantageusement, le module électronique à plaquette intercalaire rigide d'interconnexion est disposé dans une cavité à rebord interne du corps d'une carte à microcircuit, à distance du fond de la cavité, le pourtour de son support souple étant fixé par collage en appui sur le rebord interne des parois de la cavité.

Avantageusement, le module électronique à plaquette intercalaire rigide d'interconnexion est monté dans le corps d'une carte à microcircuit de type à contacts, au standard ISO 7816.

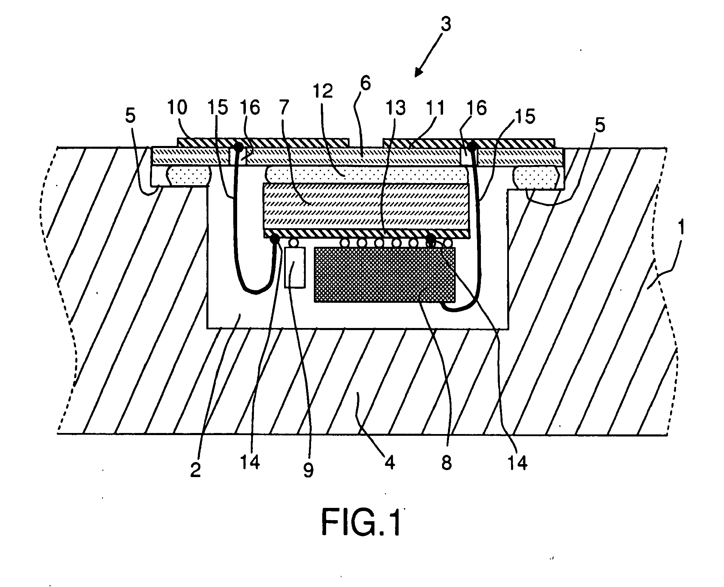

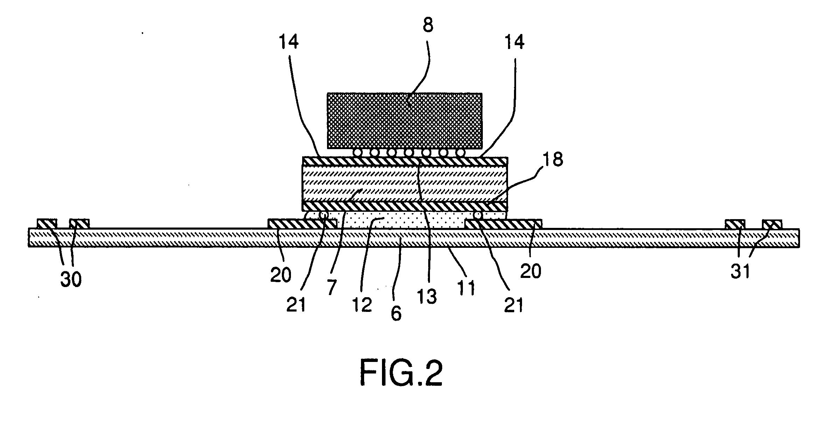

D'autres caractéristiques et avantages de l'invention ressortiront de la description ci-après d'un mode de réalisation donné à titre d'exemple. Cette description sera faite en regard du dessin dans lequel :
- une figure 1 montre en coupe, un premier exemple de module électronique selon l'invention, en place dans une cavité de carte à microcircuit à contacts, et
- une figure 2 montre, toujours en coupe, un deuxième exemple de module électronique selon l'invention alimenté et communiquant au moyen d'une antenne par couplage électromagnétique.

La figure montre une coupe partielle du corps 1 d'une carte à microcircuit de type SIM (acronyme de l'expression anglo-saxonne :"Subscriber Identity Module") conforme à la norme internationale ISO 7816 avec une épaisseur de 0,8mm et de format ID-000. Cette coupe, qui n'est pas à l'échelle, est faite au niveau d'une cavité 2 creusée dans le corps 1 de la carte à microcircuit pour loger un module électronique 3.

Le corps 1 de la carte à microcircuit est à la fois rigide et flexible. Il est réalisé à partir d'une feuille de matière plastique ou d'un laminage de plusieurs feuilles de matière plastique. La cavité 2 est obtenue par fraisage ou par pré-découpe de certaines des feuilles laminées. Sa profondeur maximum est de l'ordre de 600µm afin de conserver un fond 4 d'une épaisseur de l'ordre de 200pm garantissant la résistance mécanique et l'opacité de la carte à son niveau. Les parois latérales de la cavité 2 présentent un pourtour en forme de gradins avec un rebord interne 5 sur lequel prend appui le module électronique 3.

Le module électronique 3 comporte, un support souple 6 couramment appelé vignette, une plaquette intercalaire rigide d'interconnexion 7 et des composants électroniques tels qu'un circuit intégré 8 et un composant discret 9.

Le support souple ou vignette 6 ferme la cavité 2. Il est constitué d'une feuille d'une épaisseur de l'ordre de 150µm, en matière souple électriquement isolante, telle que du polyimide, de l'epoxy flexible ou du Polyéthylène téréphtalate film, supportant un plan de métallisation sur sa face tournée vers l'extérieur de la cavité 2. Ce plan de métallisation forme un jeu de contacts électriques 10, 11 qui affleurent à l'extérieur de la carte 1 et qui sont disposés conformément à la norme ISO 7816-2, pour un raccordement éventuel, par contacts, de la carte à microcircuit, avec un équipement de lecture. La face de la vignette 6 tournée vers le fond de la cavité 2 est dépourvue de plan de métallisation (en variante, la face de la vignette 6 tournée vers le fond de la cavité 2 comporte un plan de métallisation). Elle supporte la plaquette intercalaire rigide d'interconnexion 7 qui lui est fixé par une couche 12 de colle, d'une épaisseur d'environ 40µm.

La plaquette intercalaire rigide d'interconnexion 7 présente une ou plusieurs couches de matériau conducteur 13 sur sa face opposée à la vignette 6. Sa rigidité est suffisante pour un montage, sans problème de rendement, de circuits intégrés selon la technique de la puce retournée ("flip chip"). Elle est constituée, d'un substrat isolant de silicium 7, d'une épaisseur de l'ordre de 150µm, supportant au moins un niveau de métallisation 13, préférablement deux niveaux de métallisation isolés par une couche de passivation, reliés entre eux par des ponts conducteurs ou "vias", et comportant un ensemble de pistes conductrices obtenues par photolithographie et formant un réseau de câblage d'interconnexion pour les composants électroniques 8, 9 du module 3. En variante elle peut aussi être constituée d'une plaquette substrat en verre époxy d'une épaisseur de l'ordre de 250µm, revêtue d'une couche de matériau conducteur dans laquelle est gravée un ensemble de pistes conductrices. Il peut s'agir par exemple d'un circuit imprimé (en anglais "printed circuit board") avec un support en verre époxy ou dans un autre matériau rigide adapté.

La surface de la plaquette intercalaire rigide d'interconnexion 7 est de préférence égale ou inférieure à environ la moitié de celle de la vignette 6. Cela permet d'une part, à la vignette 6 de conserver au moins en partie sa flexibilité et, d'autre part, de limiter les risques de décollement de la plaquette intercalaire rigide d'interconnexion 7 de la vignette 6 lors des flexions imposées, en cours d'usage, à la carte à microcircuit.

Le niveau de métallisation 13 de la plaquette intercalaire rigide d'interconnexion 7, qui vient en regard des composants électroniques 8, 9 du module, présente des plots de connexion adaptés à un montage en technique "flip chip", du circuit intégré 8 et du composant discret 9 et des plots de connexion 14 adaptés à un raccordement par fils 15, selon la technique "wire bonding", avec les dos des contacts électriques affleurants 10, 11 de la vignette 6 rendus accessibles par des ouvertures 16 pratiquées au travers de la vignette 6.

Comme cela est montré en 9, la plaquette intercalaire rigide d'interconnexion 7 utilisée pour le montage de circuits intégrés 8 à multiples plots de connexion, sert également pour le montage de composants discrets 9, notamment passifs, tels que des résistances, des capacités, etc.. Cela évite la présence d'un plan de métallisation sur la face interne de la vignette 6 et donc contribue à abaisser le coût de revient du module, en rendant possible l'utilisation d'une vignette avec une seule face métallisée à la place des vignettes à deux faces métallisées utilisées dans les solutions de la technique antérieure.

La plaquette intercalaire rigide d'interconnexion 7 est particulièrement adaptée pour réaliser le montage et le câblage d'interconnexion d'une mémoire et d'un microcontrôleur disponibles sous forme de deux circuits intégrés distincts.

Le module électronique 3 est fixé à la carte à microcircuit 1 par un collage 16 du pourtour de sa vignette 6 sur le rebord interne 5 du pourtour de la cavité 2, un espace de 100 à 150µm étant ménagé entre ses composants électroniques, le fond ou certains bords de la cavité 2 pour réduire les contraintes de rupture imposées au module par les efforts de cisaillement induits par des flexions de la carte.

Le fait de rajouter une plaquette intercalaire rigide d'interconnexion à la structure d'un module n'augmente pas ou peu son encombrement en épaisseur car les composants électroniques montés sur la plaquette intercalaire rigide d'interconnexion se logent totalement ou en grande partie, dans l'épaisseur occupée par les fils de câblage du "wire bonding".

Le module électronique, qui vient d'être décrit, a été présenté monté dans le corps d'une carte à microcircuit à contacts conforme à la norme ISO 7816. Il peut bien évidemment être monté dans tous les types de carte à microcircuit du type à contacts affleurants nécessitant des modules électroniques de faible épaisseur à vignette flexible.

Il peut notamment être monté dans des cartes à microcircuit permettant en outre des communications sans contact, alimentées et communiquant au moyen d'une antenne selon la norme ISO 14443 ou NFC. Le module comporte alors (figure 2) une couche en matière plastique de la carte (de même surface que la carte) supportant des spires 30, 31 de l'antenne et constituant le support souple 6, les plots de contact affleurants (non représentés sur la figure 2 dans un souci de simplification) étant disposés sur la face externe comme représenté sur la figure 1. La plaquette intercalaire rigide est montée en "flip chip" 21 et connectée aux bornes 20 de l'antenne au moyen d'un niveau conducteur 18 prévu sur sa face opposée aux composants et raccordé (par exemple par des vias) au niveau de métallisation 13 sur lequel sont montés les composants.

La présence de la plaquette intercalaire rigide d'interconnexion permet, dans le cas des modules électroniques pour carte à microcircuit comportant des composants électroniques à multiples plots de raccordement électrique, de réduire les connexions électriques à réaliser avec un circuit imprimé souple au petit nombre des plots des contacts extérieurs de la vignette. Elle permet également de se contenter de vignettes avec un plan de métallisation au plus réservé à des contacts électriques affleurant, ce qui réduit leurs coûts et leurs épaisseurs. En permettant un montage par "flip chip ", avec un rendement amélioré, des circuits intégrés d'un module électronique, sans en augmenter notablement l'épaisseur, elle rend possible un abaissement notable du coût de fabrication des modules électroniques renfermant un ou plusieurs circuits intégrés à nombreux plots de connexion.

## Revendications

1. Module électronique (3) pour carte à microcircuit, comportant au moins un composant électronique (8, 9) à plusieurs plots de raccordement électrique et un support souple (6) avec une face dite interne tournée vers le ou lesdits composants (8, 9), et une face dite externe à plots de contacts électriques affleurants (10, 11), permettant la communication par contact à un équipement de lecture, **caractérisé en ce qu'**il comporte en outre une plaquette intercalaire rigide d'interconnexion (7) fixée à la face interne du support souple (6) par une première face et supportant, sur sa deuxième face, un ou des composants électroniques (8,9) et **en ce que** ladite plaquette comporte un réseau de câblage d'interconnexion pour les plots de contacts électriques du support souple (6) et le ou les composants électroniques, au moyen d'un câblage par fils (15) selon la technique dite "wire bonding" raccordant des plots de contact électrique (10,11) au dit réseau d'interconnexion (13) et d'un montage des composants électroniques sur la plaquette selon la technique de la puce retournée dite "flip chip".

2. Module selon la revendication 1, **caractérisé en ce que** la plaquette intercalaire rigide d'interconnexion (7) comporte un substrat de silicium supportant au moins un niveau de métallisation (13) comportant un ensemble de pistes conductrices formant un réseau de câblage d'interconnexion pour les composants électroniques (8, 9) du module.

3. Module selon la revendication 2, **caractérisé en ce que** la plaquette intercalaire rigide d'interconnexion (7) comporte un substrat de silicium supportant deux niveaux de métallisation (13) séparés par un niveau de passivation, reliés entre eux par des vias et comportant un ensemble de pistes conductrices formant un réseau de câblage d'interconnexion pour les composants électroniques (8, 9) du module.

4. Module selon l'une quelconque des revendications 1 à 3, **caractérisé en ce que** le support souple (6) supporte des spires d'antenne (30, 31) raccordées aux composants électroniques (8) du module par l'intermédiaire de la plaquette intercalaire rigide d'interconnexion (7).

5. Module selon l'une quelconque des revendications 1 à 4, **caractérisé en ce que** la plaquette intercalaire rigide d'interconnexion (7) est raccordée aux plots de contacts électriques (10, 11) de la face externe du support souple (6) par un câblage par fils passant au travers d'ouvertures (16) pratiquées dans le corps du support souple (6).

6. Module selon l'une quelconque des revendications 1 à 5, **caractérisé en ce que** la plaquette intercalaire rigide d'interconnexion (7) a une surface égale à environ la moitié de celle du support souple (6).

7. Module selon l'une quelconque des revendications 1 à 6, **caractérisé en ce que** la plaquette intercalaire rigide d'interconnexion (7) présente une épaisseur de l'ordre de 150 à 250µm.

8. Module selon l'une quelconque des revendications 1 à 7, **caractérisé en ce que** le support souple (6) a une épaisseur de l'ordre de 50µm.

9. Module selon l'une quelconque des revendications 1 à 8, **caractérisé en ce que** le support souple (6) est en polyimide.

10. Module selon l'une quelconque des revendications 1 à 8, **caractérisé en ce que** le support souple (6) est en époxy flexible.

11. Module selon l'une quelconque des revendications 1 à 10, **caractérisé en ce qu'**il est fixé par collage dans une cavité (2) d'un corps (1) de carte à microcircuit.

12. Module selon l'une quelconque des revendications 1 à 11, **caractérisé en ce qu'**il est fixé par collage dans une cavité (2) d'un corps (1) de carte à microcircuit, un espace étant laissé libre entre le module et le fond de la cavité pour mieux maitriser les contraintes transmises au module lors des flexion du corps (1) de carte.

13. Module selon l'une quelconque des revendications 1 à 12, **caractérisé en ce qu'**il est fixé dans une cavité (2) d'un corps (1) de carte par collage à un rebord de la cavité (2).

14. Module selon l'une quelconque des revendications 1 à 13, **caractérisé en ce qu'**il est monté dans le corps (1) d'une carte à microcircuit de type à contacts, au standard ISO 7816.

15. Module selon l'une quelconque des revendications 1 à 14, **caractérisé en ce que** le composant électronique (8) à plusieurs plots est un circuit intégré.

16. Module selon l'une quelconque des revendications 1 à 15, **caractérisé en ce que** la plaquette intercalaire rigide d'interconnexion (7) comporte un substrat en verre époxy revêtue d'une couche de matériau conducteur dans laquelle est gravé un ensemble de pistes conductrices.

17. Module selon l'une quelconque des revendications 1 à 15, **caractérisé en ce que** la plaquette intercalaire rigide d'interconnexion (7) est un circuit imprimé.

## Claims

1. An electronic module (3) for a microcircuit board, comprising at least one electronic component (8, 9) having several electrical connection pads and a flexible support (6) with an internal surface oriented towards the component(s) (8, 9), and an external surface having recessed electrical contact pads (10, 11), allowing communication by contact with a reading device, **characterised in that** it further comprises a rigid interposed interconnection platelet (7) fixed to the internal surface of the flexible support (6) by a first surface and supporting, on its second surface, one or more electronic components (8, 9) and **in that** said platelet includes a wiring network for interconnecting the electrical contact pads of the flexible support (6) with the electronic component(s), by means of wiring (15), using the technique referred to as "wire bonding", connecting the electrical contact pads (10, 11) to said interconnection network (13) and by means of mounting the electronic components on the platelet, using the turned chip technique referred to as "flip chip".

2. The module according to claim 1, **characterised in that** the rigid interposed interconnection platelet (7) includes a silicon substrate supporting at least one layer of metallisation (13) including a set of conducting tracks forming a wiring network for interconnecting the electronic components (8, 9) of the module.

3. The module according to claim 2, **characterised in that** the rigid interposed interconnection platelet (7) includes a silicon substrate supporting two layers of metallisation (13) separated by a passivation layer, interconnected by vias and including a set of conducting tracks forming a wiring network for interconnecting the electronic components (8, 9) of the module.

4. The module according to any one of claims 1 to 3, **characterised in that** the flexible support (6) supports antenna windings (30, 31) connected to the electronic components (8) of the module by means of the rigid interposed interconnection platelet (7).

5. The module according to any one of claims 1 to 4, **characterised in that** the rigid interposed interconnection platelet (7) is connected to the electrical contact pads (10, 11) of the external surface of the flexible support (6) by wiring passing through openings (16) realised in the body of the flexible support (6).

6. The module according to any one of claims 1 to 5, **characterised in that** the rigid interposed interconnection platelet (7) has a surface area equal to approximately half the surface area of the flexible support (6).

7. The module according to any one of claims 1 to 6, **characterised in that** the rigid interposed interconnection platelet (7) is between 150 and 250µm thick.

8. The module according to any one of claims 1 to 7, **characterised in that** the flexible support (6) is 50µm thick.

9. The module according to any one of claims 1 to 8, **characterised in that** the flexible support (6) is made from polyimide.

10. The module according to any one of claims 1 to 8, **characterised in that** the flexible support (6) is made from flexible epoxy.

11. The module according to any one of claims 1 to 10, **characterised in that** it is bonded into a cavity (2) of the microcircuit board body (1).

12. The module according to any one of claims 1 to 11, **characterised in that** it is bonded into a cavity (2) of the microcircuit board body (1), with a free space left between the module and the bottom of the cavity in order to improve management of the stresses transferred to the module when the body (1) of the board is bent.

13. The module according to any one of claims 1 to 12, **characterised in that** it is set into a cavity (2) of the board body (1) by bonding to an edge of the cavity (2).

14. The module according to any one of claims 1 to 13, **characterised in that** it is mounted into the body (1) of an ISO 7816 standard contact type microcircuit board.

15. The module according to any one of claims 1 to 14, **characterised in that** the electronic component (8) with several pads is an integrated circuit.

16. The module according to any one of claims 1 to 15, **characterised in that** the rigid interposed interconnection platelet (7) includes an epoxy glass substrate coated with a layer of conductive material into which is cut a set of conductive tracks.

17. The module according to any one of claims 1 to 15, **characterised in that** the rigid interposed interconnection platelet (7) is a printed circuit.

## Patentansprüche

1. Elektronisches Modul (3) für eine Mikrochip-Karte, das wenigstens eine elektronische Komponente (8, 9) mit mehreren elektrischen Anschlussstellen und ein flexibles Substrat (6) mit einer zu der/den Komponente(n) (8, 9) hin gewandten Innenfläche und einer Außenfläche mit eingelassenen elektrischen Kontaktstellen (10, 11) umfasst, das Kommunikationen durch Kontakt mit einem Lesegerät zulässt, **dadurch gekennzeichnet, dass** es ferner eine starre Verbindungszwischenplatine (7) umfasst, die auf einer ersten Seite an der Innenfläche des flexiblen Substrats (6) befestigt ist und auf seiner zweiten Seite eine oder mehrere elektronische Komponenten (8, 9) umfasst, und **dadurch**, dass die Platine ein Verdrahtungsnetz zum Verbinden der elektrischen Kontaktstellen des flexiblen Substrats (6) mit der/den elektronischen Komponente(n) mittels Verdrahtung (15) mit der mit "wire bonding" (Drahtbonden) bezeichneten Technik, bei der die elektrischen Kontaktstellen (10, 11) an das Verbindungsnetz (13) angeschlossen werden, und mittels Montage von elektronischen Komponenten auf der Platine mit der mit "Flip-Chip" bezeichneten Wende-Chip-Technik aufweist.

2. Modul nach Anspruch 1, **dadurch gekennzeichnet, dass** die starre Verbindungszwischenplatine (7) ein Siliciumsubstrat beinhaltet, das wenigstens eine Metallisierungsschicht (13) mit einem Satz Leiterbahnen beinhaltet, die ein Verdrahtungsnetz zum Verbinden der elektronischen Komponenten (8, 9) des Moduls bilden.

3. Modul nach Anspruch 2, **dadurch gekennzeichnet, dass** die starre Verbindungszwischenplatine (7) ein Siliciumsubstrat beinhaltet, das zwei durch eine Passivierungsschicht voneinander getrennte Metallisierungsschichten (13) beinhaltet, die durch Durchkontakte verbunden sind und einen Satz Leiterbahnen aufweisen, die ein Verdrahtungsnetz zum Verbinden der elektronischen Komponenten (8, 9) des Moduls bilden.

4. Modul nach einem der Ansprüche 1 bis 3, **dadurch gekennzeichnet, dass** das flexible Substrat (6) Antennenwindungen (30, 31) trägt, die mittels der starren Verbindungszwischenplatine (7) an den elektronischen Komponenten (8) des Moduls angeschlossen sind.

5. Modul nach einem der Ansprüche 1 bis 4, **dadurch gekennzeichnet, dass** die starre Verbindungszwischenplatine (7) mit den elektrischen Kontaktstellen (10, 11) der Außenfläche des flexiblen Substrats (6) durch Leitungen verbunden ist, die durch Öffnungen (16) im Körper des flexiblen Substrats (6) verlaufen.

6. Modul nach einem der Ansprüche 1 bis 5, **dadurch gekennzeichnet, dass** die starre Verbindungszwischenplatine (7) eine Oberfläche hat, die etwa der Hälfte von der des flexiblen Substrats (6) entspricht.

7. Modul nach einem der Ansprüche 1 bis 6, **dadurch gekennzeichnet, dass** die starre Verbindungszwischenplatine (7) eine Dicke in der Größenordnung von 150 bis 250 µm hat.

8. Modul nach einem der Ansprüche 1 bis 7, **dadurch gekennzeichnet, dass** das flexible Substrat (6) eine Dicke in der Größenordnung von 50 µm hat.

9. Modul nach einem der Ansprüche 1 bis 8, **dadurch gekennzeichnet, dass** das flexible Substrat (6) aus Polyimid besteht.

10. Modul nach einem der Ansprüche 1 bis 8, **dadurch gekennzeichnet, dass** das flexible Substrat (6) aus Epoxy besteht.

11. Modul nach einem der Ansprüche 1 bis 10, **dadurch gekennzeichnet, dass** es in einen Hohlraum (2) des Körpers (1) der Mikrochip-Karte geklebt ist.

12. Modul nach einem der Ansprüche 1 bis 11, **dadurch gekennzeichnet, dass** es in einen Hohlraum (2) des Körpers (1) der Mikrochip-Karte geklebt ist, wobei ein freier Raum zwischen dem Modul und dem Boden des Hohlraums gelassen wird, damit beim Biegen des Körpers (1) der Karte auf das Modul übertragene Spannungen besser bewältigt werden können.

13. Modul nach einem der Ansprüche 1 bis 12, **dadurch gekennzeichnet, dass** es durch Kleben auf einen Rand eines Hohlraums (2) im Hohlraum (2) des Kartenkörpers (1) befestigt wird.

14. Modul nach einem der Ansprüche 1 bis 13, **dadurch gekennzeichnet, dass** es in den Körper (1) einer Mikrochip-Karte des Kontakttyps gemäß der Norm ISO 7816 montiert wird.

15. Modul nach einem der Ansprüche 1 bis 14, **dadurch gekennzeichnet, dass** die elektronische Komponente (8) mit mehreren Kontaktstellen eine integrierte Schaltung ist.

16. Modul nach einem der Ansprüche 1 bis 15, **dadurch gekennzeichnet, dass** die starre Verbindungszwischenplatine (7) ein Epoxyglassubstrat beinhaltet, das mit einer Schicht aus leitendem Material beschichtet ist, in das ein Satz Leiterbahnen geschnitten ist.

17. Modul nach einem der Ansprüche 1 bis 15, **dadurch gekennzeichnet, dass** die starre Verbindungszwischenplatine (7) eine gedruckte Schaltung ist.
